(19) Europäisches Patentamt
European Patent Office
Office européen des brevets

(11) Veröffentlichungsnummer: **0 260 346**
**A2**

(12) # EUROPÄISCHE PATENTANMELDUNG

(21) Anmeldenummer: **86117549.5**

(51) Int. Cl.[4]: **H03H 11/24**

(22) Anmeldetag: **17.12.86**

(30) Priorität: **13.09.86 DE 3631285**

(43) Veröffentlichungstag der Anmeldung:
**23.03.88 Patentblatt 88/12**

(84) Benannte Vertragsstaaten:
**DE FR GB IT SE**

(71) Anmelder: **VDO Adolf Schindling AG**
**Gräfstrasse 103**
**D-6000 Frankfurt/Main(DE)**

(72) Erfinder: **Hannappel, Joachim**
**Blumenstrasse 21**
**D-6251 Waldbrunn 1(DE)**
Erfinder: **Pfeifer, Thomas**
**Burgstrasse 6**
**D-6239 Eppstein(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **Anordnung zur Einstellung eines analogen Widerstands auf einen wählbaren, digital vorgebbaren Wert.**

(57) Gegenstand der Erfindung ist eine Anordnung zur Einstellung eines analogen Widerstands auf einen Wert, der digital vorgegeben wird. Die Anordnung enthält einen durch eine Steuerspannung einstellbaren Widerstand (2) als Stellglied eines Regelkreises in Reihe mit einem Meßwiderstand (3) und einem Drehmagnetquotienten-Meßwerk (26). Diese Reihenschaltung wird von einer Betriebsspannung gespeist. Die Spannung am Meßwiderstand (3) und der digitale Wert werden jeweils Eingängen eines Multiplizierers (5) zugeführt, dessen Ausgänge über einen Digital/Analog-Umsetzer (6) an einen Eingang einer Subtrahierschaltung (7) angeschlossen sind. Der andere Eingang der Subtrahierschaltung (7) ist von einer Referenzspannung beaufschlagt. Der Ausgang der Subtrahierschaltung (7) erzeugt die Steuerspannung für den einstellbaren Widerstand (2).

FIG.1

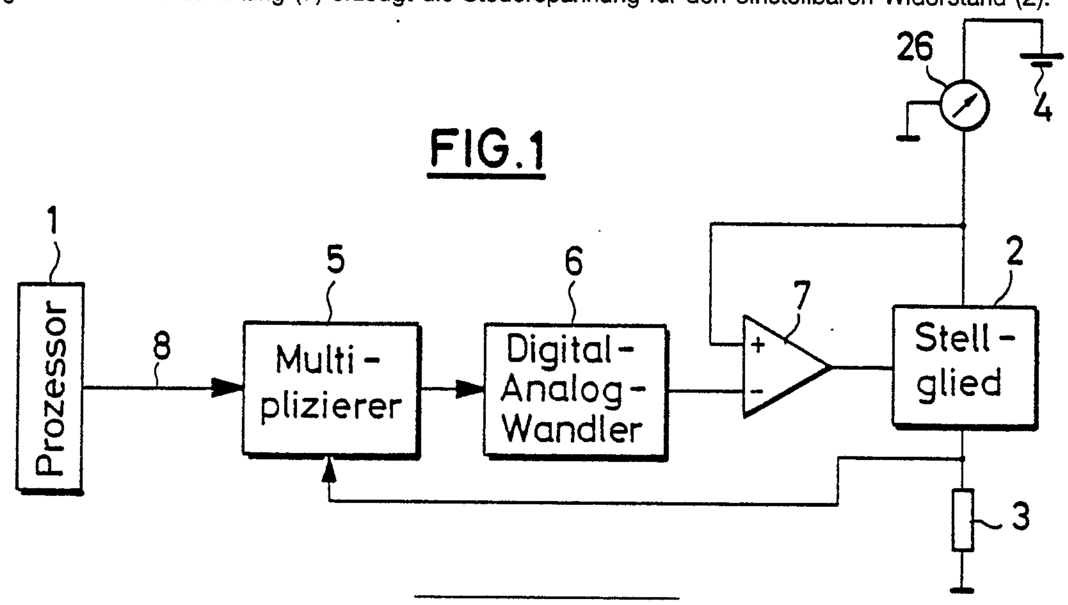


EP 0 260 346 A2

Xerox Copy Centre

# Anordnung zur Einstellung eines analogen Widerstands auf einen wählbaren, digital vorgebbaren Wert

Die Erfindung bezieht sich auf eine Anordnung zur Einstellung eines analogen Widerstands auf einen wählbaren Wert, der digital vorgegeben wird.

Für manche Anwendungsfälle müssen Widerstandswerte, die in digitaler Form erzeugt worden sind, zur Einstellung analoger Widerstände eingesetzt werden. Digitale Werte ergeben sich z.B. bei der Berechnung mit Hilfe von Mikrocomputern.

Der Erfingung liegt die Aufgabe zugrunde, eine einfache Anordnung zur Einstellung eines analogen Widerstands auf einen wählbaren digital vorgebbaren Wert zu entwickeln.

Die Aufgabe wird erfindungsgemäß dadurch gelöst, daß ein durch eine Steuerspannung einstellbarer Widerstand als Stellglied in einem Regelkreis in Reihe mit einem Meßwiderstand an eine Betriebsspannung gelegt ist und daß die Spannung am Meßwiderstand und der digitale Wert jeweils Eingängen eines Multiplizieres zugeführt werden, dessen Ausgänge über einen Digital/Analog-Umsetzer an einen Eingang einer Subtrahierschaltung angeschlossen sind, deren anderer Eingang von einer Referenzspannung beaufschlagt ist und deren Ausgang die Steuerspannung für den einstellbaren Widerstand erzeugt.

Bei dieser Anordnung wird ein gewünschter Widerstandswert mit Hilfe des über den einstellbaren Widerstand und den Meßwiderstand fließenden Strom eingestellt.

Vorzugsweise ist die am Meßwiderstand abfallende Spannung über einen nichtinvertierend geschalteten Differenzverstärker an den Eingang des Multiplizierers gelegt. Aufgrund der Verstärkung reicht eine niedrige Spannung am Meßwiderstand für die Einstellung des Widerstands auf den gewünschten Wert aus. Wegen der niedrigen Spannung läßt sich auch der Wert des Meßwiderstands niedrig halten. Durch den geringen Widerstandswert wird der Widerstand der Reihenschaltung aus einstellbarem Widerstand und Meßwiderstand überwiegend durch den einstellbaren Widerstand bestimmt, d.h. der Meßwiderstand beeinflußt den Einstellbereich des gesamten Widerstands nur in vernachlässigbar geringem Umfang.

Der einstellbare Widerstand ist vorzugsweise ein MOS-Feldeffekttransistor. Dieser Transistor benötigt nur einen kleinen Steuerstrom, so daß der Leistungsbedarf für die Ansteuerstromkreise gering ist.

Bei einer bevorzugten Ausführungsform besteht der Multiplizierer aus einer Reihe von eingangsseitig von einer der Spannung am Meßwiderstand proportionalen Spannung beaufschlagten analogen Schaltern, deren Anzahl der Zahl der parallelen Stellen des dem Widerstand zugeordneten Digitalworts entspricht und die in Abhängigkeit vom jeweiligen binären Stellenwert leitend oder nichtleitend sind, wobei die Ausgänge der Schalter je mit einem Bewertungswiderstand der Digital/Analog-Umsetzers verbunden sind. Bei dieser Anordnung wird mit einfachen Mitteln eine Multiplikation zwischen dem Digitalwort und der dem Spannungsabfall am Meßwiderstand proportionalen Spannung erreicht.

Die analogen Schalter, die vorzugsweise CMOS-Feldeffekttransistoren enthalten, sind zweckmäßigerweise je in Reihe mit den Bewertungswiderständen eines R-2R-Netzwerks des Digital/Analog-Umsetzers angeordnet, Damit wird ein sehr einfacher schaltungstechnischer Aufbau erreicht.

Es ist günstig, die Subtrahierschaltung als Differenzverstärker auszubilden, dessen nichtinvertierender Eingang von einer aus der Betriebsspannung des einstellbaren Widerstands abgeleiteten, niedrigeren Spannung beaufschlagt ist. Der analoge Widerstand wird hierbei unabhängig von Schwankungen der Betriebsspannung auf dem einmal vorgegebenen digitalen Wert gehalten.

Bei einer anderen günstigen Ausführungsform sind den Steuereingängen der analogen Schalter Invertierglieder vorgeschalter, die je von einer Stelle des Digitalworts für den Widerstand beaufschlagt sind. Mit den Invertiergliedern wird eine Komplementbildung durchgeführt.

Weitere Einzelheiten, Vorteile und Merkmale der Erfindung ergeben sich nicht nur aus den Ansprüchen und den diesen für sich und/oder in Kombination entnehmbaren Merkmalen, sondern auch aus der folgenden Beschreibung eines in einer Zeichnung dargestellten Ausführungsbeispiels.

Es zeigen:

Fig. 1 ein Blockschaltbild einer Anordnung zur Einstellung eines analogen Widerstands auf einen wählbaren Wert, der digital vorgegeben wird,

Fig. 2 ein detailliertes Schaltbild einer Anordnung zur Einstellung eines analogen Widerstands auf einen wählbaren Wert, der digital vorgegeben wird.

Ein Prozessor (1) erzeugt an beispielsweise acht parallelen Ausgängen digitale Werte, die in einer Einstellung des Werts eines analogen Widerstands umgewandelt werden sollen. Ein einstellbarer analoger Widerstand (2) ist als Stellglied eines Regelkreises in Reihe mit einem Meßwiderstand (3) und einem Drehmagnetquotienten-Meßwerk (26) zwischen den Polen einer Betriebsspannung (4) angeordnet. Der aus der Reihenschaltung des Widerstands (2) und des Meßwiderstands (3) bestehende analoge Widerstands soll auf den durch ein Digitalwort vorgegebenen Meßwiderstand eingestellt werden. Die acht parallelen

Ausgänge des Prozessors (1) sind an in Fig. 1 nicht näher dargestellte Eingänge eines Multiplizierers (5) angeschlossen, der an einem weiteren Eingang von der am Meßwiderstand (3) abfallenden Spannung beaufschlagt wird. Diese Spannung wird jeweils mit den binären Werten an den parallelen Ausgängen des Prozessors (1) multipliziert. Wenn eine oder mehrere Stellen des Digitalworts auf den parallelen Ausgängen des Prozessors (1) jeweils eine binäre "0" führe, dann treten am entsprechenden Ausgang des Multiplizierers (5) die binäre Werte "0" auf. An denjenigen Stellen des Digitalworts, die binäre "1"-Werte führen, ergeben sich auf den entsprechenden Ausgängen des Multiplizierers (5) Spannungen, die der Spannung am Meßwiderstand (3) gleich oder wenigstens proportional sind. Die acht, nicht näher dargestellten Ausgänge des Multiplizierers (5) sind an entsprechende Eingänge eines Digital/Analog-Umsetzers (6) gelegt, dessen Ausgang mit einem Eingang einer Subtrahierschaltung (7) verbunden ist, deren anderer Eingang von einer, von einer an einem Eingang des Drehmagnetquotienten Meßwerks (26) abgegriffenen Spannung beaufschlagt ist. Der Ausgang der Subtrahierschaltung (7) liefert die Steuerspannung für die Einstellung des Widerstands (2). Der digital vorgegeene Widerstandswert wird mit Hilfe des über den Widerstand (2) und den Meßwiderstand (3) fließenden Stroms eingestellt, indem die dem Strom proportionale Spannung am Meßwiderstand mit dem Digitalwort des Widerstands multipliziert wird. Hieraus ergibt sich ein dem digitalen Widerstandswert und dem Strom proportionaler Wert, der nach Digital/Analog-Umsetzung von einer Referenzspannung subtrahiert wird. Die Spannungsdifferenz stellt den Widerstandswert so ein, daß die Spannungsdifferenz ein Minimum ist. Dies ist der Fall, wenn der Quotient aus Spannung und Strom in dem den Meßwiderstand (3) und den Widerstand (2) enthaltendenen Zweig dem digital vorgegebenen Widerstandswert entspricht.

Die Fig. 2 zeigt eine Schaltungsanordnung mit acht Eingängen, die mit $D_0$ bis $D_7$ bezeichnet sind. An diesen acht Eingängen $D_0$ bis $D_7$ wird ein binärer Wert als Digitalwert eines Widerstands angelegt. Die Eingänge $D_0$ bis $D_5$ sind jeweils mit Eingängen von Invertiergliedern einer ersten integrierten Schaltung (8) verbunden. Die Eingänge $D_6$ und $D_7$ sind je an einen Eingang einer zweiten digitalen integrierten Schaltung (9) gelegt. Als integrierte Schaltungen (8, 9) werden vorzugsweise kommerziell verfügbare Bausteine der Type 7416 eingesetzt.

Die Ausgänge der eingangsseitig angeschlossenen Invertierglieder der Schaltungen (8, 9) sind jeweils über nicht näher bezeichnete Arbeitswiderstände mit einem Betriebspotential verbunden. Weiterhin sind vier Ausgänge der Schaltung (8) je mit Steuereingängen von vier in einer integrierten Schaltung (10) angeordneten kontaktlosen Schaltern verbunden, die CMOS-Feldeffekttransistoren enthalten. Je zwei eingangsseitig angeschlossene Invertierglieder der Schaltungen (8, 9) sind weiterhin an den Steuereingang eines in einer integrierten Schaltung (11) angeordneten kontaktlosen Schalters angeschlossen, der CMOS-Feldeffekttransistoren enthält. Die Schaltungen (10, 11) sind vorzugsweise die unter der Type HEF 4066 kommerziell verfügbaren Bausteine. Die Eingänge der kontaktlosen Schalter der Schaltungen (10, 11) sind gemeinsam mit dem Ausgang eines Differenzverstärkers (12) verbunden, der als nichtinvertierender Verstärker geschaltet ist und ausgangsseitig an zwei in Reihe gelegte Widerstände (13, 14) angeschlossen ist, deren Abgriff mit dem invertierenden Eingang des Differenzverstärkers (12) verbunden ist.

Der invertierende Eingang des Differenzverstärkers (12) ist mit dem Meßwiderstand (3) verbunden. Die vier Ausgänge der Schaltungen (10, 11) sind je über an Massepotential gelegte, nicht näher bezeichnete Arbeitswiderstände und mit Eingängen eines Digital/Analog-Umsetzers (15) verbunden, bei dem es sich im vorliegenden Fall um ein Widerstandsnetzwerk, ein R-2R-Netzwerk handelt, das an sich bekannt ist. Die kontaktlosen Schalter der Schaltungen (10, 11) sind je in Reihe mit einem der Widerstände des R-2R-Netwerks angeordnet. Die Anschlüsse sind so gewählt, daß die Gewichtung des Netwerks der Wertigkeit der Stellen des Digitalworts entspricht.

Der Ausgang des Ditigal/Analog-Umsetzers (15) ist mit dem invertierenden Eingang eines Differenzverstärkers (16) verbunden, dessen Ausgang über einen Widerstand (17) mit der Gate-Elektrode eines MOS-Feldeffekttransistors (18) verbunden ist, der als einstellbarer Widerstand (2) mit seiner Drain-Source-Strecke in Reihe zum Meßwiderstand (3) angeordnet ist. Die Drain-Elektrode ist über einen Zweig eines Drehmagnetquotienten-Meßwerks (26) mit dem einen Pol der Betriebsspannungsquelle (4) verbunden, deren anderer Pol an Masse gelegt ist. Ein aus zwei in Reihe angeordneten Widerständen (20, 21) bestehender Spannungsteiler ist zwischen dem Pol der Betriebsspannungsquelle abgewandten Anschluß des Drehmagnetquotienten-Meßwerks (26) und den anderen Pol der Betriebspannungsquelle gelegt. Der Abgriff des Spannungsteilers ist mit dem nichtinvertierenden Eingang des Differenzverstärkers (16) verbunden. Zu der Drain-Source-Strecke des Feldeffekttransistors (18) ist ein Widerstand (22) parallel geschaltet. Die Drain-Elektrode ist weiterhin je über einen Kondensator (23) und eine Zener-Diode (24) an Masse angeschlossen. Zwischen der Drain-und der Gate-Elektrode ist ein weiterer Kondensator (25) angeordnet.

Die Widerstände (3, 13, 14, 20, 21, 22) sind zur Verbesserung der Genauigkeit Metallwiderstände.

Am Meßwiderstand (3) tritt eine mit $U_2$ bezeichnete Spannung auf, die von einem den Feldeffekttransistor (18) und den Widerstand (22) fließenden, mit I bezeichneten Strom hervorgerufen wird.

Der Widerstand der aus dem Feldeffekttransistor (18), dem Widerstand (22) und dem Meßwiderstand 93) bestehenden Anordnung ergibt sich aus dem Quotienten der Betriebsspannung $U_1$ und dem Strom I nach der Beziehung:

$$R = \frac{U_1}{I}$$

Die Spannung $U_2$ wird durch den Differenzverstärker (12) mittels der Werte $R_{13}$ und $R_{14}$ der Widerstände (13, 14) wie folgt verstärkt:

$$U_2 \cdot \left(1 + \frac{R_{13}}{R_{14}}\right)$$

Diese Spannung wird mit dem Digitalwort multipliziert, d.h. es werden diejenigen Stellen, die binäre "I"-Werte aufweisen, in den Schaltungen (10, 11) mit der Spannung:

$$U_2 \cdot \left(1 + \frac{R_{13}}{R_{14}}\right)$$

multipliziert, so daß die Widerstände des Digital/Analog-Umsetzers (15) von einer entsprechenden Differenzspannung beaufschlagt sind. An den acht Eingängen der Schaltungen (10, 11) liegt jedoch nicht das Digitalwort, das dem Widerstandswert zugeordnet ist, sondern dessen komplementärer Wert an. Wird das Digitalwort an den Eingängen der Schaltungen (10, 11) mit D bezeichnet, dann besteht zwischen dem an den Eingängen $D_0$ -$D_7$ anstehenden und mit $D_{Ein}$ bezeichneten Digitalwort folgende Beziehung:

$D = 256 - D_{Ein}$

Am nichtinvertierenden Eingang des Differenzverstärkers (16) steht dann eine Spannung an, die von den Werten $R_{20}$ und $R_{21}$ der Widerstände (20, 21) wie folgt abhängt.

$$\frac{U_1 \cdot R_{20}}{R_{20} + R_{21}}$$

Durch den Regelkreis wird die Ausgangsspannung des D-A-Wandlers (15) in etwa auf dem Wert:

$$\frac{U_1 \cdot R_{20}}{R_{20} + R_{21}}$$

gehalten.

Für den Widerstand R der aus dem Feldeffekttransistor (18), dem paralleleln Widerstand (22) und dem Meßwiderstand (3) bestehenden Schaltung ergibt sich folgende Nährungsgleichung:

$$R = \frac{U_1}{I}, \text{ d. h.: } R = R_2 \cdot D \cdot \frac{b \cdot k}{a}$$

Hierbei gilt:

$$b = 1 + \frac{R_{13}}{R_{14}}$$

Für den Wert a gilt:

$$a = \frac{R_{20}}{R_{20} + R_{21}}$$

Für den Wert k gilt:

$$k = \frac{1}{512}$$

aufgrund der Konstanten des Digital/Analog-Umsetzers (15).

Durch die Kondensatoren (23, 25) wird eine Schwingunterdrückung erreicht. Die Zener-Diode (24) begrenzt die am Feldeffekttransistor (18) anstehende Spannung auf einen ungefährlichen Wert, was zum Schutz des Ausgangs bestimmt ist.

Die aus dem Feldeffekttransistor (18), dem parallelen Widerstand (22) und dem Meßwiderstand (3) bestehende Anordnung ist vorzugsweise in einem Zweig eines Quotienten-Meßwerks angeordnet.

Da die Spannung $U_2$ verstärkt wird, kann der Meßwiderstand (3) einen sehr kleinen Wert haben. Für den Widerstand des aus dem Feldeffekttransistor (18) dem Widerstand (22) und dem Meßwiderstand (3) bestehenden Anordnung ist dann im wesentlichen nur der Feldeffekttransistor (18) in Verbindung mit dem parallel geschalteten Widerstand (22) von Bedeutung. Der parallele Widerstand (22) legt die obere Grenze des Widerstands fest, wenn der Feldeffekttransistor (18) vollständig gesperrt ist.

## Ansprüche

1. Anordnung zur Einstellung eines analogen Widerstands auf einen wählbaren Wert, der digital vorgegeben wird,

**dadurch gekennzeichnet,**

daß ein durch eine Steuerspannung einstellbarer Widerstand (2) als Stellglied in einem Regelkreis in Reihe mit einem Meßwiderstand (3) an eine Betriebsspannung gelegt ist und daß die Spannung am Meßwiderstand (3) und der digitale Wert jeweils Eingängen eines Multiplizierers (5) zugeführt werden,

dessen Ausgänge über einen Digital/Analog-Umsetzer (6) an einen Eingang einer Subtrahierschaltung (7) angeschlossen sind, deren anderer Eingang von einer Referenzspannung beaufschlagt ist und deren Ausgang die Steuerspannung für den einstellbaren Widerstand (2) erzeugt.

2. Anordnung nach Anspruch 1,
**dadurch gekennzeichnet,**
daß die am Meßwiderstand (3) abfallende Spannung ($U_2$) über einen nicht invertierend geschalteten Differenzverstärker (12) an den Eingang des Multiplizierers (5) gelegt ist.

3. Anordnung nach Anspruch 1 oder 2,
**dadurch gekennzeichnet,**
daß der Multiplizierer (5) aus einer Reihe von eingangsseitig von einer der Spannung am Meßwiderstand (3) proportionalen Spannung beaufschlagten analogen Schaltern besteht, deren Anzahl der Zahl der parallelen Stellen des dem Widerstand zugeordneten Digitalworts entspricht und die in Abhängigkeit vom jeweiligen binären Stellenwert leitend oder nichtleitend sind, wobei die Ausgänge der Schalter je mit einem Bewertungswiderstand des Digital/Analog-Umsetzers (15) verbunden sind.

4. Anordnung nach einem der vorhergehenden Ansprüche,
**dadurch gekennzeichnet,**
daß die analogen Schalter CMOS-Feldeffekttransistoren enthalten, die je in Reihe mit den Bewertungswiderständen eines R-2R-Netzwerkes des Digital/Analog-Umsetzers (15) angeordnet sind.

5. Anordnung nach einem der vorhergehenden Ansprüche,
**dadurch gekennzeichnet,**
daß die Subtrahierschaltung (7) als Differenzverstärker (16) ausgebildet ist, dessen nichtinvertierender Eingang von einer aus der Betriebsspannung des einstellbaren Widerstands (2) abgeleiteten niedrigeren Spannung beaufschlagt ist.

6. Anordnung nach einem der vorhergehenden Ansprüche,
**dadurch gekennzeichnet,**
daß den Steuereingängen der analogen Schalter jeweils Invertierglieder vorgeschaltet sind, die je von einem einer binären Stelle eines Digitalworts für den Widerstand zugeordneten Wert beaufschlagt sind.

7. Anordnung nach einem der vorhergehenden Ansprüche,
**dadurch gekennzeichnet,**
daß ein Kondensator (25) zwischen der Gate-Elektrode und der Drain-Elektrode des als MOS-Feldeffekttransistors (18) ausgebildeten, einstellbaren Widerstands (2) angeordnet ist.

8. Anordnung nach einem der vorhergehenden Ansprüche,
**dadurch gekennzeichnet,**
daß ein Widerstand (22) zu der Drain-Source-Strecke des Feldeffekttransistors (18) parallel geschaltet ist.

9. Anordnung nach einem der vorhergehenden Ansprüche,
**dadurch gekennzeichnet,**
daß ein weiterer Kondensator (23) zwischen der Drain-Elektrode des Feldeffekttransistors und dem zweiten Pol der Betriebsspannungsquelle (4) angeordnet ist.

10. Anordnung nach einem der vorhergehenden Ansprüche,
**dadurch gekennzeichnet,**
daß der einstellbare Widerstand (2) und der Meßwiderstand (3) in Reihe mit einer Wicklung eines Quotienten-Meßwerks an die Betriebsspannungsquelle angeschlossen sind.

11. Anordnung nach Anspruch 10,
**dadurch gekennzeichnet,**
daß das Quotienten-Meßwerk ein Drehmagnetquotienten-Meßwerk (26) ist.

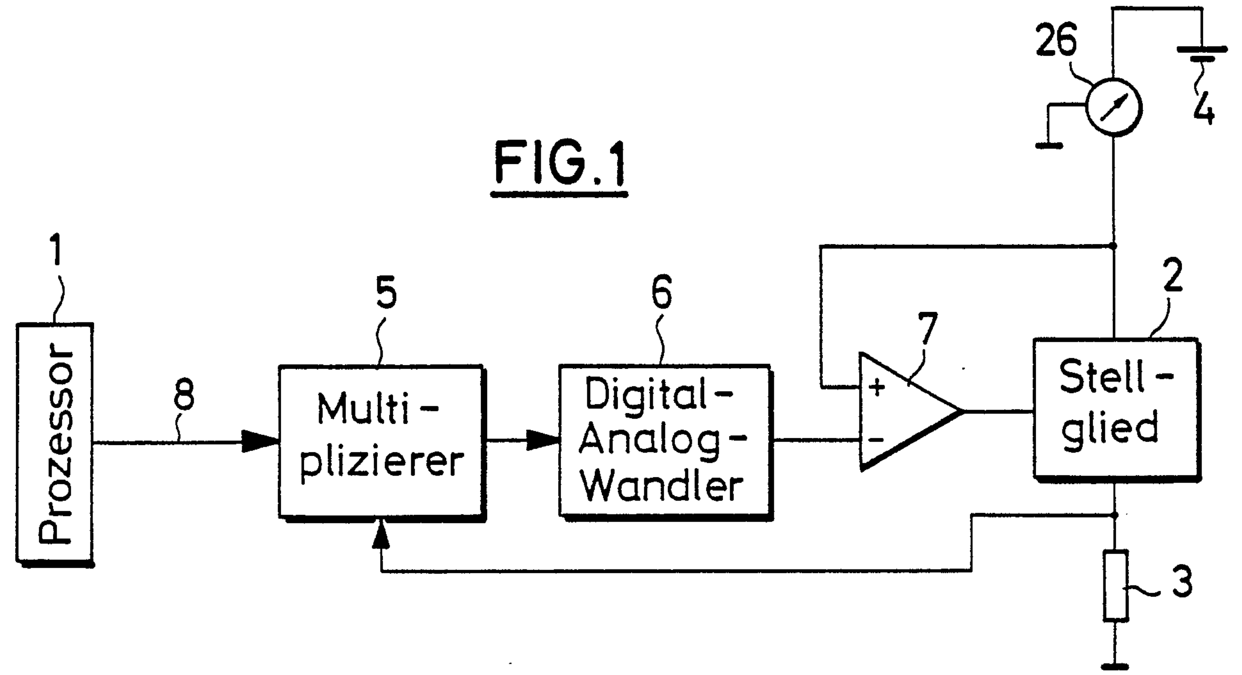
26
4
1
5
6
7
2
8
Prozessor
Multi-
plizierer
Digital-
Analog-
Wandler
Stell-
glied
3

FIG.1

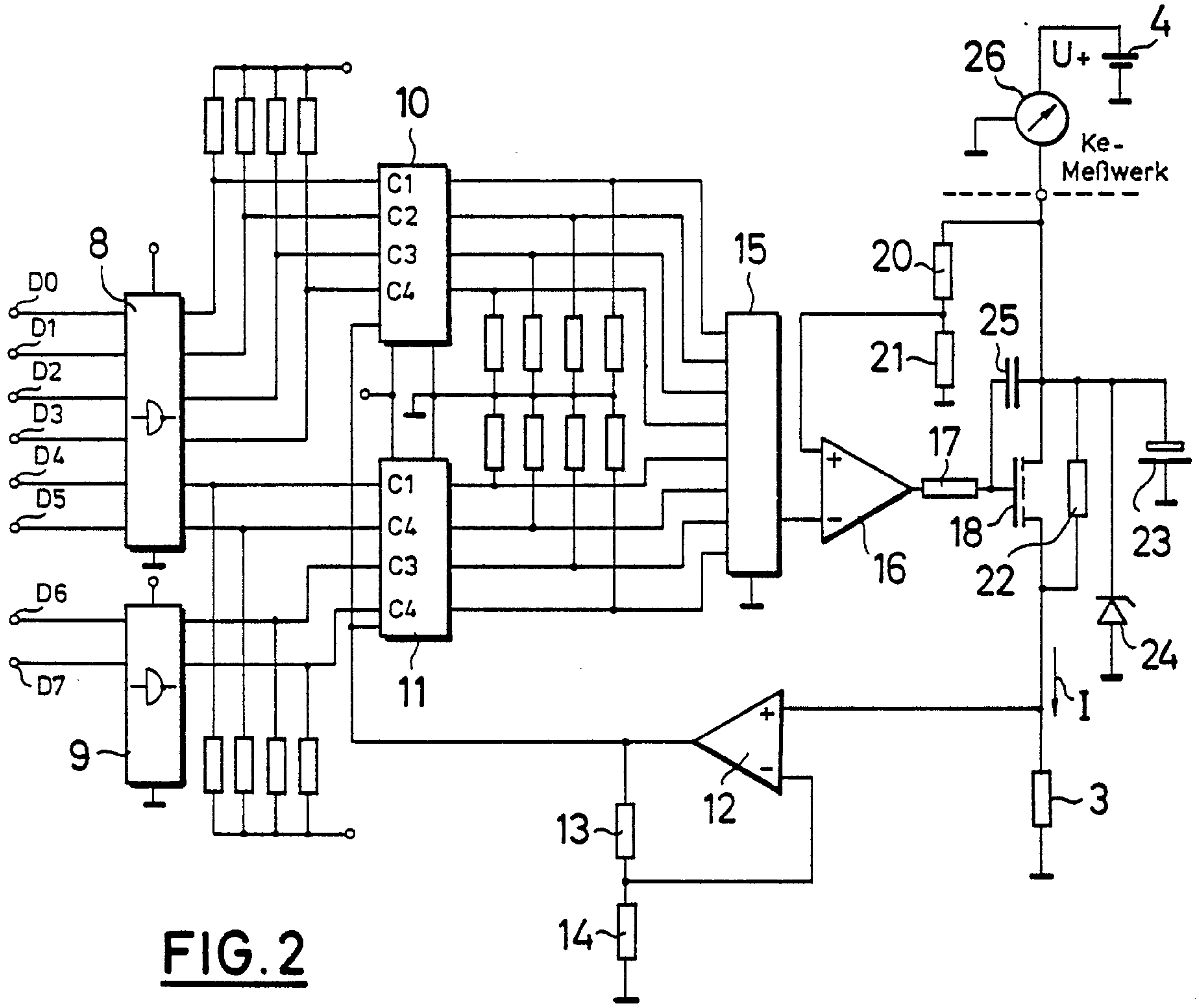
10
26
U+
4
Ke-
Meßwerk
8
15
20
21
25
D0
D1
D2
D3
D4
D5
D6
D7
C1
C2
C3
C4
C1
C4
C3
C4
17
16
18
22
23
24
11
9
I
12
13
14
3

FIG.2